# EUROPÄISCHE PATENTSCHRIFT

(11) **EP 1 924 724 B1**
(45) Veröffentlichungstag und Bekanntmachung des Hinweises auf die Patenterteilung: **29.12.2010**
(21) Anmeldenummer: 06791817.7
(22) Anmeldetag: 04.09.2006
(51) Int. Cl.: C30B 13/24

(54) **VERFAHREN ZUR REKRISTALLISIERUNG VON SCHICHTSTRUKTUREN MITTELS ZONENSCHMELZEN UND DESSEN VERWENDUNG**
METHOD FOR RECRYSTALLISING LAYER STRUCTURES OF BY ZONE MELTING AND THE USE THEREOF
PROCEDE DE RECRISTALLISATION DE STRUCTURES DE COUCHES PAR LE PROCESSUS DE LA ZONE FONDUE ET SON UTILISATION

(30) Priorität: 12.09.2005 DE 102005043303
(43) Veröffentlichungstag der Anmeldung: 28.05.2008
(73) Patentinhaber: Fraunhofer-Gesellschaft zur Förderung der angewandten Forschung e.V., 80686 München (DE)
(72) Erfinder: REBER, Stefan, 79194 Gundelfingen (DE); EYER, Achim, 79104 Freiburg (DE); HAAS, Fridolin, 79199 Kirchzarten (DE)
(74) Vertreter: Pfenning, Meinig & Partner GbR
(86) Internationale Anmeldenummer: PCT/EP2006/008611
(87) Internationale Veröffentlichungsnummer: WO 2007/031209

(56) Entgegenhaltungen:
- WO-A-89/12317
- WO-A-2004/023538
- JP-A- 60 191 092
- US-A- 4 578 144

## Beschreibung

Die Erfindung betrifft ein Verfahren zur Rekristallisierung von Schichtstrukturen mittels Zonenschmelzen, bei dem durch geschickte Anordnung mehrerer Wärmequellen eine deutliche Beschleunigung des Zonenschmelz-Verfahrens erreicht werden kann. Das Verfahren basiert darauf, dass durch entstehende Überlappungen eine lückenlose Rekristallisierung der Schicht gewährleistet wird. Erfindungsgemäß wird ebenso eine Vorrichtung bereitgestellt, mit der das erfindungsgemäße Verfahren realisiert werden kann. Verwendung findet das erfindungsgemäße Verfahren insbesondere bei der Herstellung kristalliner Silizium-Dünnschichtsolarzellen oder z.B. in der SOI-Technologie. Die Anwendung betrifft aber ebenso auch allgemein die Verarbeitung von Metallen, Kunststoffen oder Klebstoffen und hier insbesondere die Herstellung dünner Schichten.

Die Herstellung von dünnen dotierten Halbleiterschichten für die Elektronik und Photovoltaik wird derzeit auf verschiedenste Art und Weise durchgeführt. Im Allgemeinen ist es das Ziel, sandwichartige Schichtstrukturen aus unterschiedlich dotierten Teilschichten zu realisieren. Dabei kommen typischerweise mehrere Prozessschritte zum Einsatz, die die Schichtstrukturen sequentiell aufbauen. Für Solarzellen aus kristallinem Silizium ist die Kristallstruktur von grundlegender Bedeutung für den erreichbaren Wirkungsgrad. Je defektärmer der Kristall ist, desto einfacher wird die Herstellung hocheffizienter Solarzellen.

Stand der Technik auf dem Gebiet der Halbleiterschichtstrukturen sind Verfahren, bei denen der Halbleiter nach einem Abscheideschritt noch über die Flüssigphase rekristallisiert wird, um z.B. die Kristallstruktur zu ändern. Eine solche Anwendung ist z.B. in der "Silicon on Insulator" (SOI)-Technologie oder auch im Bereich der kristallinen Silizium-Dünnschichtsolarzellen gegeben.

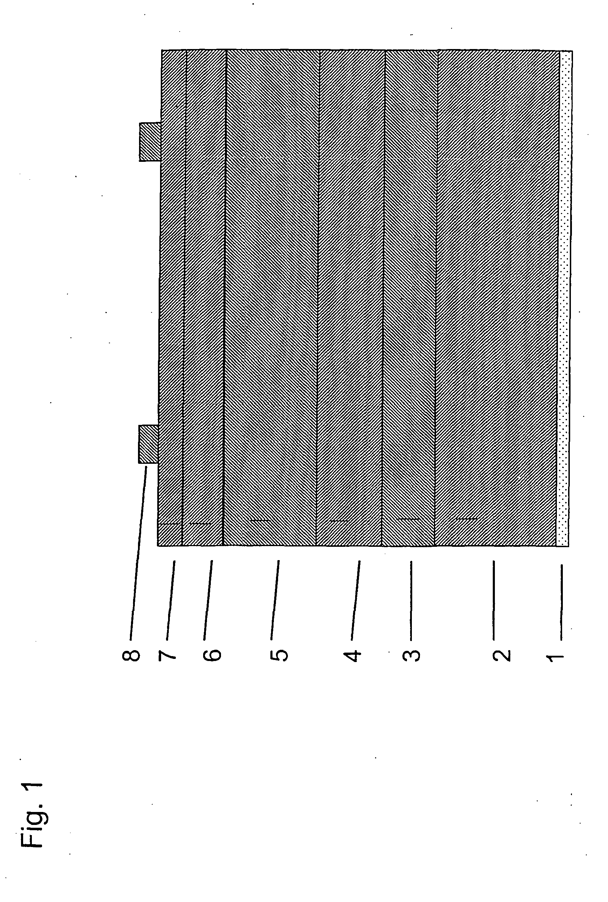

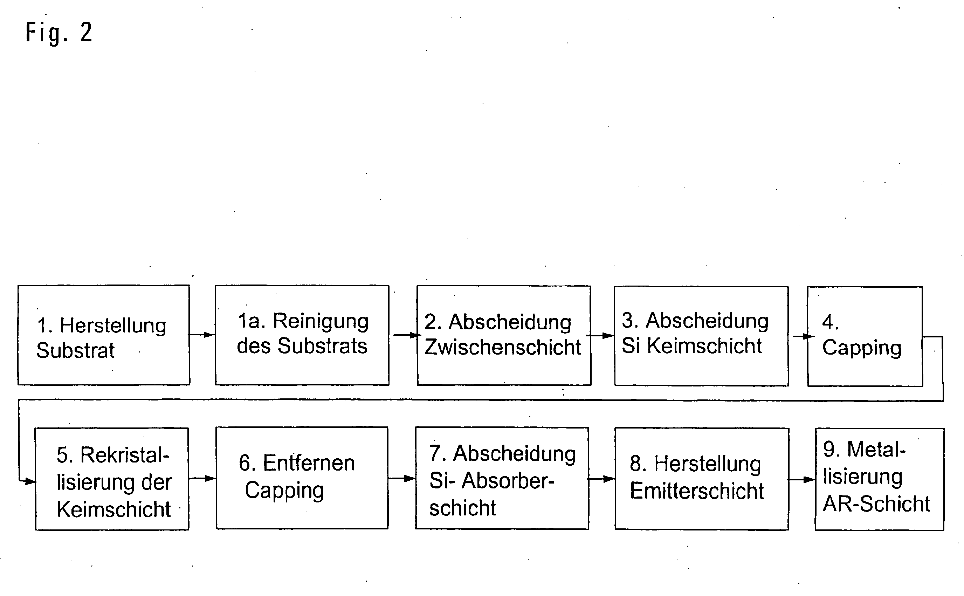

Kristalline Silizium-Dünnschichtsolarzellen werden derzeit in unterschiedlichen Konzepten untersucht. Eines dieser Konzepte ist beispielhaft in Fig. 1 dargestellt. Für die Herstellung einer in Fig. 1 dargestellten Solarzelle sind die in Fig. 2 dargestellten Fertigungsschritte erforderlich. Der in Fig. 2 dargestellte Verfahrensschritt der Rekristallisierung der Schicht über die Flüssigphase kann mittels verschiedener Verfahren durchgeführt werden. Eines dieser Verfahren ist das Zonenschmelzen (engl. zone melting recrystallization, ZMR). Dabei wird die in Fig. 1 dargestellte Keimschicht von einer linienförmigen oder linienförmig gescannten Wärmequelle derart erhitzt, dass sie linienförmig über die gesamte Breite des Substrates aufschmilzt. Diese geschmolzene Linie, d.i. die Schmelzzone, wird durch eine Relativbewegung von Substrat und Wärmequelle in senkrechter Richtung zur Schmelzzone in der Substratebene durch die gesamte Substratlänge gezogen. JP-A-60191092 beschreibt ein solches Verfahren.

Abhängig von der Ziehgeschwindigkeit und dem Temperaturgradienten an den Schmelzzonengrenzen entstehen Kristalle, die in Ziehrichtung ausgedehnt sind und unterschiedliche Abmessungen haben. Typisches Ziel jenes Zonenschmelz-Prozesses ist es, möglichst große und defektarme Kristalle herzustellen. Dieses Ziel läuft aber im Falle der Verwendung eines Zonenschmelz-Prozesses für die Photovoltaik den ökonomischen Zielvorgaben für einen kostengünstigen Prozess entgegen. Unter ökonomischen Aspekten muss der Durchsatz so hoch wie möglich, d.h. mindestens 0,1 m²/min, sein, wobei gleichzeitig die bei moderaten Ziehgeschwindigkeiten mögliche hohe Kristallqualität erhalten bleiben soll.

Ausgehend hiervon war es Aufgabe der vorliegenden Erfindung, ein Zonenschmelz-Verfahren bereitzustellen, bei dem der Durchsatz des Zonenschmelz-Verfahrens von der Ziehgeschwindigkeit entkoppelt ist und somit hohe Kristallqualitäten bei gleichzeitig hohem Durchsatz ermöglicht werden.

Diese Aufgabe wird durch die Verfahren mit den Merkmalen der Ansprüche 1 bis 3 gelöst. In den Ansprüchen 10 bis 12 werden erfindungsgemäße Verwendungen genannt. Die weiteren abhängigen Ansprüche zeigen vorteilhafte Weiterbildungen auf.

Erfindungsgemäß wird ein Verfahren zur Rekristallisierung von Schichtstrukturen mittels Zonenschmelzen bereitgestellt, bei dem die mit mindestens zwei Wärmequellen linienförmig erzeugten Schmelzzonen durch die Schicht mittels einer Relativbewegung der Wärmequellen zu der Schicht in senkrechter Richtung zu den linienförmigen Schmelzzonen gezogen werden. Dabei werden die Schmelzzonen simultan durch die gesamte Schicht unter bereichsweiser Überlappung der Schmelzzonen mit bereits rekristallisierten Schmelzzonen gezogen, sodass eine lückenlose Rekristallisierung der Schicht ermöglicht wird.

Erfindungswesentlich ist es dabei, dass mehrere Wärmequellen hinter- oder nebeneinander geschaltet werden, aber durch geschickte Steuerung der pro Zeiteinheit in die Schmelzzonen eingekoppelten Heizenergie ein Wechsel zwischen optimalem Zonenschmelzen und schnellem Transport ohne den Verlust der gewonnenen Kristallqualität erfolgt. Dieser Wechsel erlaubt es, die erfindungsgemäße Aufgabe zu lösen.

Vorzugsweise wird die Relativbewegung durch einen Transport der Schicht ermöglicht. Eine andere bevorzugte Variante sieht vor, dass die Relativbewegung von den Wärmequellen zu der Schicht durch einen Transport der Wärmequellen realisiert wird. Es ist aber ebenso möglich, dass ein Transport sowohl der Schicht als auch der Wärmequellen erfolgt.

Vorzugsweise wird das Verfahren so durchgeführt, dass die Schmelzzonen in senkrechter Richtung zu den linienförmigen Schmelzzonen bereichsweise mit bereits rekristallisierten Schmelzzonen überlappen. Hierfür ist es erforderlich, dass die mindestens zwei Wärmequellen in senkrechter Richtung zu den linienförmigen Schmelzzonen hintereinander angeordnet werden, wobei die Abstände zwischen benachbarten Wärmequellen gleich groß sind. Dies führt dazu, dass beliebig viele Schmelzzonen kaskadenförmig hintereinander etabliert werden.

Grundsätzlich lässt sich das erfindungsgemäße Verfahren in eine Schmelzphase und in eine Transportphase unterteilen. Während der Schmelzphase erfolgt die Relativbewegung zwischen Schicht und Wärmequelle gerade so schnell, dass eine optimale Schmelzzonenausbildung und Rekristallisierung erreicht wird. Während der Transportphase wird die Geschwindigkeit erhöht und vorzugsweise die eingekoppelte Leistung der Wärmequellen verringert, sodass die Schmelzzone zusammenbricht, d.h. entweder nicht mehr oder nicht mehr vollständig vorhanden ist. Wesentlich hierbei ist es, dass die Schicht nicht mehr im vollen Querschnitt aufschmilzt, sodass eine vorhandene Kristallstruktur durch die Schmelzzone nicht zerstört wird. Die Aneinanderreihung der genannten Phasen führt dazu, dass in der Schmelzphase eine durch Anzahl und Anordnung der Wärmequellen beliebig vorgegebene Strecke mit hoher resultierender Kristallqualität umgeschmolzen wird und anschließend in der Transportphase diese Strecke bis auf eine kleine Überlappung übersprungen wird, ohne die in der Schmelzphase erreichte hohe Kristallqualität zu zerstören. Da die Transportphase mit weit höherer Vorschubgeschwindigkeit als die Schmelzphase durchlaufen wird, hat man einen wesentlich höheren Durchsatz der erfindungsgemäßen Vorrichtung als bei Verwendung eines Schmelzheizers, wie er aus dem Stand der Technik bekannt ist.

Hinsichtlich der Durchführung des Verfahrens sind drei Varianten bevorzugt.

Nach einer ersten erfindungsgemäßen Variante werden in einer ersten Phase, d.i. die Schmelzphase, die mindestens zwei Schmelzzonen in zu den linienförmigen Schmelzzonen senkrechter Richtung über eine Strecke d+a durch die Schicht gezogen. Die Relativbewegung der Schmelzzonen erfolgt dabei simultan. Die Geschwindigkeit ist dabei so gewählt, dass eine hohe Kristallqualität ermöglicht wird. Die Strecke d entspricht hierbei dem Abstand zweier benachbarter Wärmequellen. Die für die Überlappung verantwortliche Strecke a ist so gewählt, dass diese kleiner als d ist, wobei es bevorzugt ist, dass das Verhältnis von a zu d im Bereich von 1:4 bis 1:100 liegt.

Anschließend erfolgt in einer zweiten Phase, d.i. die Transportphase, der Transport der Schicht über eine sich an die erste Strecke in zu den linienförmigen Schmelzzonen senkrechter Richtung anschließende zweite Strecke. Diese zweite Strecke besitzt dabei eine Länge von (n-1)•d-b, wobei n die Anzahl der hintereinander angeordneten Wärmequellen darstellt und b so gewählt ist, dass es zu einer Überlappung der Schmelzzonen mit den bereits rekristallisierten Zonen kommt. In der Transportphase wird die Geschwindigkeit erhöht, wodurch die in der Schmelzphase rekristallisierte Schicht nicht aufgeschmolzen wird. Die Schmelzphase und die Transportphase werden so lange wiederholt, bis eine lückenlose Rekristallisierung der Schicht erreicht ist.

Diese erste Variante beruht somit darauf, dass die Schicht transportiert wird, während die Wärmequellen stationär sind.

Eine zweite erfindungsgemäße Variante sieht vor, dass in einer ersten Phase, d.i. die Schmelzphase, die mindestens zwei Wärmequellen in zu den linienförmigen Schmelzzonen senkrechter Richtung simultan über eine erste Strecke d+a bewegt werden, wobei d den Abstand zweier benachbarter Wärmequellen darstellt und a kleiner d ist. Auch hier ist es wieder bevorzugt, dass a wesentlich kleiner als d ist, z.B. im Bereich von 1:4 bis 1:100, da, je kleiner die Strecke a gewählt ist, desto geringer die Überlappung wird und somit der Durchsatz erhöht wird. In der Schmelzphase wird die Geschwindigkeit so gering gewählt, dass eine hohe Kristallqualität ermöglicht wird.

In der Transportphase werden anschließend die mindestens zwei Wärmequellen über eine Strecke -(d+a) zurückbewegt, d.h. die Wärmequelle wird zu ihrem Ausgangspunkt zurücktransportiert. Anschließend wird dann die Schicht in hierzu entgegengesetzter Richtung über eine Strecke n*d+a-b bewegt, wobei die Geschwindigkeit im Vergleich zu der Geschwindigkeit in der Schmelzphase erhöht wird, um ein Aufschmelzen der Schicht zu verhindern. Auch hier bedeutet n die Anzahl der hintereinander angeordneten Wärmequellen und b ist so gewählt, dass es zu einer Überlappung der Schmelzzonen mit den bereits rekristallisierten Zonen kommt. Der Transport der Schicht kann dabei ebenso auch in der gleichen Richtung wie die Bewegungsrichtung der Schmelzzone bewegt werden. Allerdings bietet der Transport entgegengesetzt der Richtung der Schmelzphase den Vorteil, dass der neue Startzyklus von einem bereits rekristallisierten Überlappungsbereich des vorhergehenden Zyklus ausgeht.

Die Schmelzphase und die Transportphase werden alternierend so lange durchgeführt, bis die lückenlose Rekristallisierung der Schicht realisiert ist. In der hier beschriebenen zweiten bevorzugten Variante werden somit sowohl die Wärmequellen als auch die Schicht transportiert.

Eine dritte erfindungsgemäße Variante des erfindungsgemäßen Verfahrens sieht vor, dass in einer ersten Schmelzphase die mindestens zwei Schmelzzonen in zu den linienförmigen Schmelzzonen senkrechter Richtung simultan über eine erste Strecke d+a gezogen werden, wobei die Geschwindigkeit so gewählt wird, dass eine hohe Kristallqualität ermöglicht wird. Die Strecken d und a besitzen die zuvor beschriebene Bedeutung.

In einer zweiten Phase, d.i. die Transportphase, werden die mindestens zwei Wärmequellen und/oder die Schicht über eine sich an die erste Strecke in zu den linienförmigen Schmelzzonen senkrechter Richtung anschließende zweite Strecke n*d+a-b bewegt, wobei die Geschwindigkeit gegenüber der ersten Schmelzphase erhöht wird, sodass die Schicht nicht aufgeschmolzen werden kann. N bedeutet hier die Anzahl der hintereinander angeordneten Wärmequellen und b ist so gewählt, dass es zu einer Überlappung der Schmelzzonen mit den bereits rekristallisierten Schmelzzonen kommt.

In einer weiteren Phase, der zweiten Schmelzphase, werden dann die mindestens zwei Schmelzzonen in zu den linienförmigen Schmelzzonen senkrechter Richtung simultan über eine Strecke -(d+a) gezogen, wobei die Geschwindigkeit so gewählt ist, dass eine hohe Kristallqualität ermöglicht wird. Die Strecken d und a besitzen die zuvor beschriebene Bedeutung.

In einer vierten Phase, in der zweiten Transportphase, werden wiederum die mindestens zwei Wärmequellen und/oder die Schicht über eine sich an die erste Strecke hin zu den linienförmigen Schmelzzonen senkrecht der Richtung anschließende zweite Strecke n*d+a-b bewegt. Auch hier wird wiederum die Geschwindigkeit gegenüber den Schmelzphasen erhöht. Die genannten Variablen haben die zuvor beschriebene Bedeutung und sind so gewählt, dass auch hier wieder eine Überlappung der Schmelzzonen mit den bereits rekristallisierten Schmelzzonen ermöglicht wird.

Die zuvor genannten drei Verfahrensschritte werden so lange wiederholt, bis eine lückenlose Rekristallisierung der Schicht erreicht ist. In der hier beschriebenen dritten bevorzugten Verfahrensvariante bewegen sich somit sowohl die Wärmequellen als auch die Schicht.

Vorzugsweise wird in der Transportphase die Temperatur der Wärmequellen reduziert.

Vorzugsweise erfolgt die Bewegung der Wärmequellen und/oder der Schicht, d.h. die Relativbewegung zwischen beiden, in der Transportphase mit einer Geschwindigkeit, die um einen Faktor im Bereich von 2 bis 100 höher ist als in der Schmelzphase. Dieser Faktor ist dabei stark abhängig von der Anzahl der Schmelzzonen und somit der Wärmequellen. So ist z.B. bei 10 Wärmequellen ein Faktor 2 bereits sehr effektiv, während bei nur zwei Wärmequellen ein Faktor von 10 oder mehr zu wählen ist.

Eine weitere bevorzugte Alternative des erfindungsgemäßen Verfahrens sieht vor, dass die mindestens zwei Wärmequellen in senkrechter Richtung zu den linienförmigen Schmelzzonen nebeneinander angeordnet werden, wobei die nebeneinander angeordneten Wärmequellen zueinander jeweils einen Versatz in zu den linienförmigen Schmelzzonen senkrechter Richtung aufweisen. Dies ermöglicht, dass die durch die Wärmequellen erzeugten Schmelzzonen in senkrechter Richtung zu den linienförmigen Schmelzzonen bereichsweise überlappen können. Durch eine Überlappung der einzelnen Schmelzreihen wird gewährleistet, dass die komplette Fläche der Schicht lückenlos rekristallisiert wird. Auch bei dieser erfindungsgemäßen Alternative können die einzelnen Wärmequellen beliebig aber äquidistant auf Vorder- und/oder Rückseite verteilt sein.

Vorzugsweise sind die Wärmequellen unabhängig voneinander ausgewählt aus der Gruppe bestehend aus Elektronenstrahlheizer, Laserstrahlquellen, Graphitstreifenheizer, Halogenlampenheizer, IR-Strahler und UV-Strahler. Sämtliche der zuvor genannten Wärmequellen können auch miteinander kombiniert werden.

Vorzugsweise ist die zu rekristallisierte Schicht mit einem Substrat verbunden. Hinsichtlich der Verbindung zwischen der Schicht und dem Substrat sind alle aus dem Stand der Technik bekannten Varianten möglich.

Hinsichtlich der Anordnung der Wärmequellen besteht keinerlei Beschränkung, sodass diese unabhängig voneinander vorderseitig und/oder rückseitig zur Oberfläche der Schicht und/oder des Substrats angeordnet sein können.

Das erfindungsgemäße Verfahren kann mit einer Vorrichtung zur Rekristallisierung von Schichtstrukturen mittels Zonenschmelzen mit mindestens zwei linienförmigen Wärmequellen durchgeführt werden. Durch die Wärmequellen werden in einer Schicht Schmelzzonen erzeugt, wobei die Wärmequellen so angeordnet und bewegbar sind, dass sich die Schmelzzonen mit bereits rekristallisierten Zonen bereichsweise überlappen und so eine lückenlose Rekristallisierung der Schicht gewährleistet wird.

In einer bevorzugten Variante sind die Wärmequellen in senkrechter Richtung zu den linienförmigen Schmelzzonen nebeneinander angeordnet, wobei die nebeneinander angeordneten Wärmequellen zueinander jeweils ein Versatz in zu den linienförmigen Schmelzzonen senkrechter Richtung aufweisen, sodass sich die durch die Wärmequellen erzeugten Schmelzzonen bereichsweise überlappen.

Eine andere bevorzugte Variante sieht vor, dass mindestens vier Wärmequellen arrayartig zur Halbleiterschicht angeordnet sind, wobei die nebeneinander angeordneten Wärmequellen zueinander jeweils ein Versatz in zu den linienförmigen Schmelzzonen senkrechter Richtung aufweisen, sodass sich die durch die Wärmequellen erzeugten Schmelzzonen bereichsweise überlappen.

Vorzugsweise sind die Wärmequellen unabhängig voneinander aus der Gruppe bestehend aus Elektronenstrahlheizern, Laserstrahlquellen, Graphitstreifenheizern, Halogenlampenheizern, IR-Strahlern und UV-Strahlern. Diese können auch beliebig miteinander kombiniert werden.

Eine weitere bevorzugte Variante der Vorrichtung sieht vor, dass die Wärmequellen mit Fokussierspiegeln versehen sind.

Erfindungsgemäß wird das beschriebene Verfahren zur Herstellung von kristallinen Silizium-Dünnschichtsolarzellen oder in der SOI-Technologie eingesetzt. Losgelöst davon kann das Verfahren aber auch allgemein zur Verarbeitung von Metallen, Kunststoffen oder Klebstoffen verwendet werden.

Anhand der nachfolgenden Figuren soll der erfindungsgemäße Gegenstand näher erläutert werden, ohne diesen auf die hier gezeigten speziellen Ausführungsformen einschränken zu wollen.
Fig. 1 zeigt in einer schematischen Darstellung den Aufbau einer aus dem Stand der Technik bekannten Silizium-Dünnschichtsolarzelle.
Fig. 2 zeigt anhand eines Flussdiagramms den Prozessablauf zur Herstellung rekristallisierter Silizium-Dünnschichtsolarzellen.
Fig. 3 zeigt eine Schnittzeichnung der erfindungsgemäßen Vorrichtung.
Fig. 4 zeigt anhand einer schematischen Darstellung eine erfindungsgemäße Variante mit entsprechender arrayartiger Anordnung der Wärmequellen.

In Fig. 1 ist eine aus dem Stand der Technik bekannte Silizium-Dünnschichtsolarzelle dargestellt, die auf einem mit einem Basiskontakt 1 auf der Rückseite versehenen Substrat 2 basiert. Auf dem Substrat ist eine Zwischenschicht 3 angeordnet, die wiederum von einer Keimschicht 4 überdeckt ist. Bei der Keimschicht handelt es sich um eine rekristallisierte und hochdotierte Siliziumschicht. Auf der Keimschicht wiederum ist eine Absorberschicht 5 abgeschieden, die normal dotiert ist. Das Schichtsystem wird durch eine Emitterschicht 6 und eine Antireflex- bzw. Passivierungsschicht 7 abgeschlossen. Auf diesem Schichtstapel ist dann noch ein Emitterkontakt 8 aufgebracht.

Fig. 2 zeigt schematisch den Ablauf des Herstellungsverfahrens für das in Fig. 1 dargestellte Schichtsystem. Der erfindungswesentliche Kern betrifft hierbei den Schritt 5 der Rekristallisierung der Keimschicht, der gemäß dem Zonenschmelz-Verfahren durchgeführt wird.

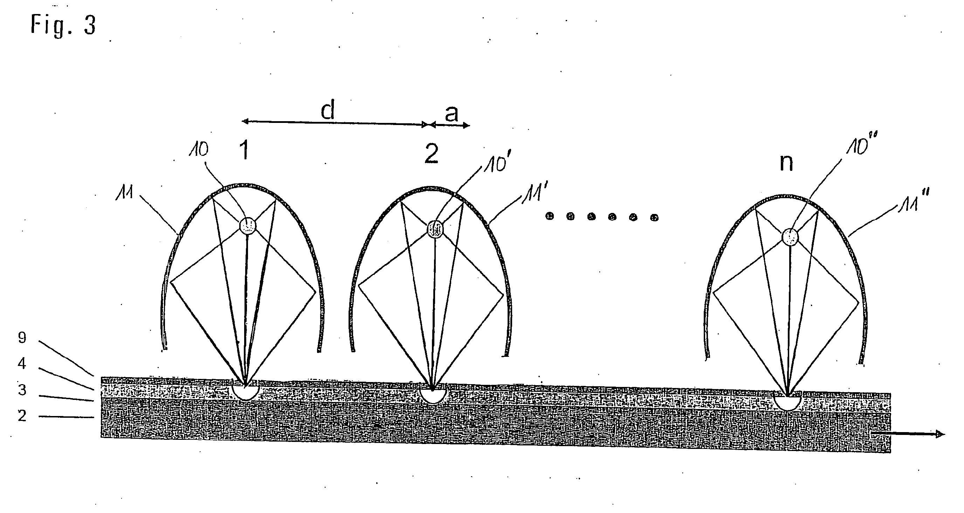

Fig. 3 zeigt schematisch die erfindungsgemäße Verfahrensführung, bei der eine Kaskade von Wärmequellen 10, 10', 10" in der Vorrichtung eingesetzt wird. Die Gesamtkaskade besteht aus bis zu n Wärmequellen. Die einzelnen Wärmequellen sind von dazugehörigen Fokussierspiegeln 11, 11' und 11" umgeben, mit denen die Wärmestrahlung auf die Schichtstruktur fokussiert wird. Die Schichtstruktur besteht hierbei wieder aus einem Substrat 2, einer Zwischenschicht 3 sowie der zu rekristallisierenden Keimschicht 4. Diese ist durch eine optionale Deckschicht 9 abgedeckt. Der Abstand zwischen den einzelnen Wärmequellen ist hier mit einer Länge d angegeben, wobei der Transport während der Schmelzphase noch um einen weiteren Streckenabschnitt a weitergeführt wird, um eine Überlappung der Schmelzzonen sicherzustellen.

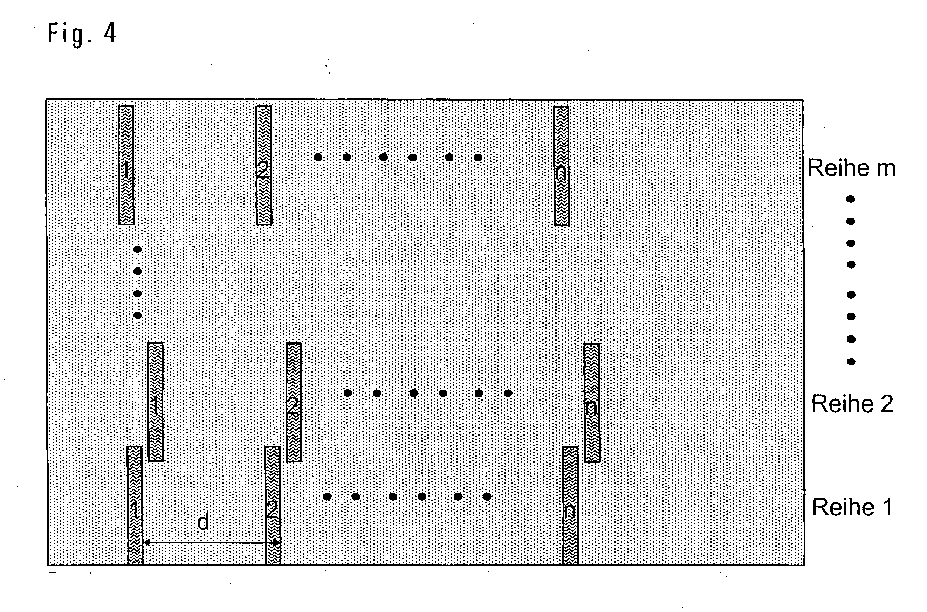

Fig. 4 zeigt eine besonders bevorzugte Variante des erfindungsgemäßen Verfahrens. Hierbei sind die einzelnen Wärmequellen sowohl nebeneinander als auch hintereinander angeordnet, was zu einer arrayartigen Anordnung führt. Durch den angedeuteten Versatz der Wärmequellen in den verschiedenen Reihen kommt es zu einer Überlappung der "Schmelzreihen". Innerhalb jeder einzelnen Reihe wiederum sind n Wärmequellen angeordnet, wobei auch die durch diese Wärmequellen erzeugten Schmelzzonen überlappen. Durch diese arrayartige Anordnung kann der Durchsatz des Zonenschmelz-Prozesses nochmals erhöht werden.

## Patentansprüche

1. Verfahren zur Rekristallisierung von Schichtstrukturen mittels Zonenschmelzen,
bei dem mit mindestens zwei Wärmequellen linienförmig erzeugte Schmelzzonen durch die Schicht mittels einer Relativbewegung der Wärmequellen zu der Schicht in senkrechter Richtung zu den linienförmigen Schmelzzonen gezogen werden, wobei die Schmelzzonen simultan durch die gesamte Schicht unter bereichsweiser Überlappung der Schmelzzonen mit bereits rekristallisierten Zonen gezogen werden, so dass eine lückenlose Rekristallisierung der Schicht gewährleistet wird,
**dadurch gekennzeichnet, dass**
a) in einer ersten Phase (Schmelzphase) die mindestens zwei Schmelzzonen in zu den linienförmigen Schmelzzonen senkrechter Richtung simultan über eine erste Strecke d + a und mit einer eine hohe Kristallqualität ermöglichenden Geschwindigkeit durch die Schicht gezogen werden, wobei d den Abstand zweier benachbarter Wärmequellen darstellt und a < d, und
b) die Schicht in einer zweiten Phase (Transportphase) über eine sich an die erste Strecke in zu den linienförmigen Schmelzzonen senkrechter Richtung anschließende zweite Strecke (n-1) · d - b und mit einer gegenüber der ersten Phase erhöhten Geschwindigkeit bewegt werden, bei der die Schicht nicht aufgeschmolzen wird, wobei n die Anzahl der hintereinander angeordneten Wärmequellen darstellt und b so gewählt ist, dass es zu einer Überlappung der Schmelzzonen mit den bereits rekristallisierten Zonen kommt,
wobei die Schritte a) und b) bis zur lückenlosen Rekristallisierung der Schicht wiederholt werden.

2. Verfahren zur Rekristallisierung von Schichtstrukturen mittels Zonenschmelzen,
bei dem mit mindestens zwei Wärmequellen linienförmig erzeugte Schmelzzonen durch die Schicht mittels einer Relativbewegung der Wärmequellen zu der Schicht in senkrechter Richtung zu den linienförmigen Schmelzzonen gezogen werden, wobei die Schmelzzonen simultan durch die gesamte Schicht unter bereichsweiser Überlappung der Schmelzzonen mit bereits rekristallisierten Zonen gezogen werden, so dass eine lückenlose Rekristallisierung der Schicht gewährleistet wird,
**dadurch gekennzeichnet, dass**
a) in einer ersten Phase (Schmelzphase) die mindestens zwei Wärmequellen in zu den linienförmigen Schmelzzonen senkrechter Richtung simultan über eine erste Strecke d + a und mit einer eine hohe Kristallqualität ermöglichenden Geschwindigkeit bewegt werden, wobei d den Abstand zweier benachbarter Wärmequellen darstellt und a < d, und
b) die Wärmequellen in einer zweiten Phase (Transportphase) über eine Strecke -(d+a) bewegt wird und die Schicht in hierzu entgegen gesetzter Richtung über eine Strecke n*d+a-b und mit einer gegenüber der ersten Phase erhöhten Geschwindigkeit bewegt werden, bei der die Schicht nicht aufgeschmolzen wird, wobei n die Anzahl der hintereinander angeordneten Wärmequellen darstellt und b so gewählt ist, dass es zu einer Überlappung der Schmelzzonen mit den bereits rekristallisierten Zonen kommt,
wobei die Schritte a) und b) bis zur lückenlosen Rekristallisierung der Schicht wiederholt werden.

3. Verfahren zur Rekristallisierung von Schichtstrukturen mittels Zonenschmelzen,
bei dem mit mindestens zwei Wärmequellen linienförmig erzeugte Schmelzzonen durch die Schicht mittels einer Relativbewegung der Wärmequellen zu der Schicht in senkrechter Richtung zu den linienförmigen Schmelzzonen gezogen werden, wobei die Schmelzzonen simultan durch die gesamte Schicht unter bereichsweiser Überlappung der Schmelzzonen mit bereits rekristallisierten Zonen gezogen werden, so dass eine lückenlose Rekristallisierung der Schicht gewährleistet wird,
**dadurch gekennzeichnet, dass**
a) in einer ersten Schmelzphase die mindestens zwei Schmelzzonen in zu den linienförmigen Schmelzzonen senkrechter Richtung simultan über eine erste Strecke d + a und mit einer eine hohe Kristallqualität ermöglichenden Geschwindigkeit durch die Schicht gezogen werden, wobei d den Abstand zweier benachbarter Wärmequellen darstellt und a < d,
b) die Wärmequellen und/oder die Schicht in einer zweiten Phase (Transportphase) über eine sich an die erste Strecke in zu den linienförmigen Schmelzzonen senkrechter Richtung anschließende zweite Strecke n*d+a-b und mit einer gegenüber der ersten Phase erhöhten Geschwindigkeit bewegt werden, bei der die Schicht nicht aufgeschmolzen wird, wobei n die Anzahl der hintereinander angeordneten Wärmequellen darstellt und b so gewählt ist, dass es zu einer Überlappung der Schmelzzonen mit den bereits rekristallisierten Zonen kommt,
c) in einer zweiten Schmelzphase die mindestens zwei Schmelzzonen in zu den linienförmigen Schmelzzonen senkrechter Richtung simultan über eine Strecke -(d+a) und mit einer eine hohe Kristallqualität ermöglichenden Geschwindigkeit durch die Schicht gezogen werden, wobei d den Abstand zweier benachbarter Wärmequellen darstellt und a < d und
d) in einer zweiten Transportphase die Wärmequellen und/oder die Schicht über eine sich an die erste Strecke hin zu den linienförmigen Schmelzzonen senkrecht der Richtung anschließende zweite Wegstrecke n*d+a-b und mit einer gegenüber der ersten Phase erhöhten Geschwindigkeit bewegt werden, bei der die Schicht nicht ausgeschmolzen wird, wobei n die Anzahl der hintereinander angeordneten Wärmequellen darstellt und b so gewählt ist, dass es zu einer Überlappung der Schmelzzonen mit den bereits rekristallisierten Zonen kommt,
wobei die Schritte a), b), c) und d) bis zur lückenlosen Rekristallisierung der Schicht wiederholt werden.

4. Verfahren nach einem der Ansprüche 1 bis 3,
**dadurch gekennzeichnet, dass** in der Transportphase die Temperatur der Wärmequellen reduziert wird.

5. Verfahren nach einem Ansprüche 1 bis 4, **dadurch gekennzeichnet, dass** die Wärmequellen in der Transportphase mit einer um einen Faktor im Bereich von 2 bis 100 höheren Geschwindigkeit als in a) bewegt werden.

6. Verfahren nach einem der vorhergehenden Ansprüche,
**dadurch gekennzeichnet, dass** die Wärmequellen in senkrechter Richtung zu den linienförmigen Schmelzzonen nebeneinander angeordnet werden, wobei die nebeneinander angeordneten Wärmequellen zueinander jeweils einen Versatz in zu den linienförmigen Schmelzzonen senkrechter Richtung aufweisen, so dass sich die durch die Wärmequellen erzeugten Schmelzzonen bereichsweise überlappen.

7. Verfahren nach einem der vorhergehenden Ansprüche, **dadurch gekennzeichnet, dass** die Wärmequellen unabhängig voneinander ausgewählt sind aus der Gruppe bestehend aus Elektronenstrahlheizer, Laserstrahlquellen, Graphitstreifenheizer, Halogenlampenheizer, IR-Strahler und UV-Strahler.

8. Verfahren nach einem der vorhergehenden Ansprüche, **dadurch gekennzeichnet, dass** die Schicht mit einem Substrat verbunden ist.

9. Verfahren nach einem der vorhergehenden Ansprüche, **dadurch gekennzeichnet, dass** die Wärmequellen unabhängig voneinander vorderseitig und/oder rückseitig zur Oberfläche der Schicht und/oder des Substrats angeordnet sind.

10. Verwendung des Verfahrens nach einem der Ansprüche 1 bis 9 zur Herstellung von kristallinen Silicium-Dünnschichtsolarzellen.

11. Verwendung des Verfahrens nach einem der Ansprüche 1 bis 9 in der SOI-Technologie.

12. Verwendung des Verfahrens nach einem der Ansprüche 1 bis 9 zur Verarbeitung von Metallen, Kunststoffen oder Klebstoffen.

## Claims

1. A method for the re-crystallisation of layer structures by means of zone melting, in which linear melting zones produced using at least two heat sources are drawn through the layer by means of movement of the heat sources relative to the layer in a direction perpendicular to the linear melting zones, wherein the melting zones are simultaneously drawn through the entire layer with an overlap of the melting zones with already re-crystallised zones in some regions so that a continuous re-crystallisation of the layer is ensured,
**characterised in that**
a) in a first phase (melting phase), the at least two melting zones are simultaneously drawn through the layer in the direction perpendicular to the linear melting zones over a first section d + a and at a speed which permits a high crystal quality, wherein d represents the spacing of two adjacent heat sources and a < d,
b) the layer are moved in a second phase (transport phase) over a second section (n-1) · d - b which is subsequent to the first section in the direction perpendicular to the linear melting zones and at a speed which is increased relative to the first phase, at which the layer is not melted, wherein n represents the number of consecutively arranged heat sources and b is selected such that overlapping of the melting zones with the already re-crystallised zones occurs,
steps a) and b) being repeated until there is continuous re-crystallisation of the layer.

2. A method for the re-crystallisation of layer structures by means of zone melting, in which linear melting zones produced using at least two heat sources are drawn through the layer by means of movement of the heat sources relative to the layer in a direction perpendicular to the linear melting zones, wherein the melting zones are simultaneously drawn through the entire layer with an overlap of the melting zones with already re-crystallised zones in some regions so that a continuous re-crystallisation of the layer is ensured,
**characterised in that**
a) in a first phase (melting phase), the at least two heat sources are simultaneously moved in the direction perpendicular to the linear melting zones over a first section d + a and at a speed which permits a high crystal quality, wherein d represents the spacing of two adjacent heat sources and a < d, and
b) the heat sources is moved in a second phase (transport phase) over a section -(d+a) and the layer are moved in the opposite direction thereto over a section n*d+a-b and at a speed which is increased relative to the first phase, at which the layer is not melted, wherein n represents the number of consecutively arranged heat sources and b is selected such that overlapping of the melting zones with the already re-crystallised zones occurs,
steps a) and b) being repeated until there is continuous re-crystallisation of the layer.

3. A method for the re-crystallisation of layer structures by means of zone melting, in which linear melting zones produced using at least two heat sources are drawn through the layer by means of movement of the heat sources relative to the layer in a direction perpendicular to the linear melting zones, wherein the melting zones are simultaneously drawn through the entire layer with an overlap of the melting zones with already re-crystallised zones in some regions so that a continuous re-crystallisation of the layer is ensured,
**characterised in that**
a) in a first melting phase the at least two melting zones are simultaneously drawn through the layer in the direction perpendicular to the linear melting zones over a first section d + a and at a speed which permits a high crystal quality, wherein d represents the spacing of two adjacent heat sources and a < d,
b) the heat sources and/or the layer are moved in a second phase (transport phase) over a second section n*d+a-b which is subsequent to the first section in the direction perpendicular to the linear melting zones and at a speed which is increased relative to the first phase, at which the layer is not melted, wherein n represents the number of consecutively arranged heat sources and b is selected such that overlapping of the melting zones with the already re-crystallised zones occurs,
c) in a second melting phase, the at least two melting zones are simultaneously drawn through the layer in the direction perpendicular to the linear melting zones over a section -(d+a) and at a speed which permits a high crystal quality, wherein d represents the spacing of two adjacent heat sources and a < d and
d) in a second transport phase, the heat sources and/or the layer are moved over a second distance n*d+a-b which is subsequent to the first section towards the direction perpendicular of the linear melting zones and at a speed which is increased relative to the first phase, at which the layer is not melted out, wherein n represents the number of consecutively arranged heat sources and b is selected such that overlapping of the melting zones with the already re-crystallised zones occurs,
steps a), b), c) and d) being repeated until there is continuous re-crystallisation of the layer.

4. The method according to one of claims 1 to 3, **characterised in that** the temperature of the heat sources is reduced in the transport phase.

5. The method according to one claims 1 to 4, **characterised in that** the heat sources are moved in the transport phase at a speed which is higher than in a) by a factor in the range of 2 to 100.

6. The method according to one of the preceding claims, **characterised in that** the heat sources are arranged adjacent to one another in the direction perpendicular to the linear melting zones, the heat sources arranged adjacent to one another each having an offset relative to one another in the direction perpendicular to the linear melting zones so that the melting zones produced by the heat sources overlap in regions.

7. The method according to one of the preceding claims, **characterised in that** the heat sources are selected independently of one another from the group consisting of electron beam heaters, laser beam sources, graphite strip heaters, halogen lamp heaters, IR radiators and UV radiators.

8. The method according to one of the preceding claims, **characterised in that** the layer is joined to a substrate.

9. The method according to one of the preceding claims, **characterised in that** the heat sources are arranged independently of one another on the front side and/or on the reverse side relative to the surface of the layer and/or of the substrate.

10. The use of the method according to one of claims 1 to 9 for the production of crystalline silicon thin-film solar cells.

11. The use of the method according to one of claims 1 to 9 in SOI technology.

12. The use of the method according to one of claims 1 to 9 for the processing of metals, plastics or adhesives.

## Revendications

1. Procédé pour la recristallisation de structures stratifiées par la méthode de la zone fondue, dans lequel on tire à travers la couche des zones fondues générées en forme linéaire avec au moins deux sources de chaleur au moyen d'un mouvement relatif des sources de chaleur par rapport à la couche dans une direction perpendiculaire aux zones fondues en forme linéaire, les zones fondues étant tirées simultanément à travers toute la couche en formant, par segments, un chevauchement des zones fondues avec les zones déjà recristallisées, de sorte qu'une recristallisation sans vides de la couche soit garantie,
**caractérisé en ce que**,
a) dans une première phase (phase de fusion), les au moins deux zones fondues sont tirées simultanément à travers la couche dans la direction perpendiculaire aux zones fondues en forme linéaire sur un premier tronçon d + a et à une vitesse permettant une qualité de cristal élevée, où d représente la distance entre deux sources de chaleur voisines et a < d, et
b) dans une seconde phase (phase de transport), la couche est déplacée sur un second tronçon (n - 1).d - b se raccordant au premier tronçon dans la direction perpendiculaire aux zones fondues en forme linéaire et à une vitesse accrue par rapport à celle de la première phase, à laquelle la couche n'est pas fondue, n représentant le nombre des sources de chaleur aménagées l'une derrière l'autre et b est sélectionné de manière à obtenir un chevauchement des zones fondues avec les zones déjà recristallisées,
dans lequel les étapes a) et b) sont répétées jusqu'à ce que l'on obtienne une recristallisation sans vides de la couche.

2. Procédé pour la recristallisation de structures stratifiées par la méthode de la zone fondue, dans lequel on tire à travers la couche des zones fondues générées en forme linéaire avec au moins deux sources de chaleur au moyen d'un mouvement relatif des sources de chaleur par rapport à la couche dans une direction perpendiculaire aux zones fondues en forme linéaire, les zones fondues étant tirées simultanément à travers toute la couche en formant, par segments, un chevauchement des zones fondues avec les zones déjà recristallisées, de sorte qu'une recristallisation sans vides de la couche soit garantie,
**caractérisé en ce que**,
a) dans une première phase (phase de fusion), les au moins deux sources de chaleur sont déplacées dans la direction perpendiculaire aux zones fondues en forme linéaire simultanément sur un premier tronçon d + a et à une vitesse permettant une qualité de cristal élevée, où d représente la distance entre deux sources de chaleur voisines et a < d, et
b) dans une seconde phase (phase de transport), les sources de chaleur sont déplacées sur un tronçon -(d + a) et la couche est déplacée dans le sens opposé à ce déplacement sur un tronçon n*d+a-b et à une vitesse accrue en comparaison de celle de la première phase, où la couche n'est pas fondue, n représente le nombre de sources de chaleur aménagées l'une derrière l'autre et b est sélectionné de manière à obtenir un chevauchement des zones fondues avec les zones déjà recristallisées,
les étapes a) et b) étant répétées jusqu'à ce que l'on obtienne une recristallisation sans vides de la couche.

3. Procédé pour la recristallisation de structures stratifiées par la méthode de la zone fondue, dans lequel on tire à travers la couche des zones fondues générées en forme linéaire à l'aide d'au moins deux sources de chaleur au moyen d'un mouvement relatif des sources de chaleur par rapport à la couche dans une direction perpendiculaire aux zones fondues en forme linéaire, les zones fondues étant tirées simultanément à travers toute la couche en formant, par segments, un chevauchement des zones fondues avec des zones déjà recristallisées, de sorte qu'une recristallisation sans vides de la couche soit garantie,
**caractérisé en ce que**,
a) dans une première phase de fusion, les au moins deux zones fondues sont tirées à travers la couche dans la direction perpendiculaire aux zones fondues en forme linéaire simultanément sur un premier tronçon d + a et à une vitesse permettant une qualité de cristal élevée, d représentant la distance entre deux sources de chaleur voisines et a < d,
b) dans une seconde phase (phase de transport), les sources de chaleur et/ou la couche est ou sont ensuite déplacées sur un second tronçon n*d+a-b se raccordant au premier tronçon dans la direction perpendiculaire aux zones fondues en forme linéaire et à une vitesse accrue par rapport à celle de la première phase, où la couche n'est pas fondue, n représentant le nombre de sources de chaleur aménagées l'une derrière l'autre et b étant sélectionné de manière à obtenir un chevauchement des zones fondues avec les zones déjà recristallisées,
c) dans une seconde phase de fusion, les au moins deux zones fondues sont tirées à travers la couche dans la direction perpendiculaire aux zones fondues en forme linéaire simultanément sur un tronçon -(d + a) et à une vitesse permettant une qualité de cristal élevée, d représentant la distance entre deux sources de chaleur voisines et a < d,
d) dans une seconde phase de transport, les sources de chaleur et/ou la couche est ou sont déplacées sur un second tronçon n*d+a-b se raccordant au premier tronçon dans la direction perpendiculaire aux zones fondues en forme linéaire et à une vitesse accrue par rapport à celle de la première phase, où la couche n'est pas fondue, n représentant le nombre de sources de chaleur aménagées l'une derrière l'autre et b est sélectionné de manière à obtenir un chevauchement des zones fondues avec les zones déjà recristallisées,
les étapes a), b), c) et d) étant répétées jusqu'à ce que l'on obtienne une recristallisation sans vides de la couche.

4. Procédé selon l'une quelconque des revendications 1 à 3, **caractérisé en ce que**, dans la phase de transport, la température des sources de chaleur est diminuée.

5. Procédé selon l'une quelconque des revendications 1 à 4, **caractérisé en ce que** les sources de chaleur sont déplacées dans la phase de transport à une vitesse plus rapide d'un facteur dans la plage de 2 à 100 en comparaison de celle de l'étape a).

6. Procédé selon l'une quelconque des revendications précédentes, **caractérisé en ce que**
les sources de chaleur sont aménagées l'une à côté de l'autre dans la direction perpendiculaire aux zones fondues en forme linéaire, dans lequel les sources de chaleur aménagées l'une à côté de l'autre présentent respectivement un décalage l'une par rapport à l'autre dans la direction perpendiculaire aux zones fondues en forme linéaire, de sorte que les zones fondues produites par les sources de chaleur se chevauchent par segments.

7. Procédé selon l'une quelconque des revendications précédentes, **caractérisé en ce que** les sources de chaleur sont choisies indépendamment l'une de l'autre dans le groupe comprenant des dispositifs de chauffage à faisceau électronique, des sources de faisceau laser, des dispositifs de chauffage à bandes de graphite, des dispositifs de chauffage à lampe halogène, des dispositifs à rayonnement infrarouge et des dispositifs à rayonnement UV.

8. Procédé selon l'une quelconque des revendications précédentes, **caractérisé en ce que** la couche est liée à un substrat.

9. Procédé selon l'une quelconque des revendications précédentes, **caractérisé en ce que** les sources de chaleur sont aménagées indépendamment l'une de l'autre sur le côté avant et/ou le côté arrière par rapport à la surface de la couche et/ou du substrat.

10. Utilisation du procédé selon l'une quelconque des revendications 1 à 9 pour la fabrication de piles solaires cristallines à couche mince de silicium.

11. Utilisation du procédé selon l'une quelconque des revendications 1 à 9 dans la technologie SOI.

12. Utilisation du procédé selon l'une quelconque des revendications 1 à 9 pour le traitement de métaux, de matériaux synthétiques ou d'adhésifs.
